# EUROPEAN PATENT SPECIFICATION

(11) **EP 4 349 771 B1**
(45) Date of publication and mention of the grant of the patent: **13.05.2026**
(21) Application number: 23195331.6
(22) Date of filing: 05.09.2023
(51) Int. Cl.: B81C 1/00

(54) **SENSING DEVICE AND METHOD OF MANUFACTURING SENSING DEVICE**
MESSVORRICHTUNG UND VERFAHREN ZUR HERSTELLUNG DER MESSVORRICHTUNG
DISPOSITIF DE DÉTECTION ET PROCÉDÉ DE FABRICATION DE DISPOSITIF DE DÉTECTION

(30) Priority: 30.09.2022 US 202263411631 P; 14.06.2023 CN 202310705290
(43) Date of publication of application: 10.04.2024
(73) Proprietor: InnoLux Corporation, Jhunan Town Miao li 35053 (TW)
(72) Inventor: YAO, I-AN, 35053 Jhunan Town, Miaoli County (TW); LIU, Yu-Tsung, 35053 Jhunan Town, Miaoli County (TW)
(74) Representative: Becker, Eberhard

(56) References cited:
- FR-A1- 3 113 126
- US-A1- 2022 185 660

## Description

### BACKGROUND

### Technical Field

The disclosure relates to a sensing device and a method of manufacturing a sensing device.

### Description of Related Art

The existing sensing device includes a supporting part and a sensing part, in which the supporting part may be used, for example, to form a resonant cavity with a reflective layer and a cavity, so as to improve an absorption rate of the sensing part. However, a sensing area of the sensing part is easily affected by a disposed position of the supporting part and thus is limited. FR 3 113 126 A1 discloses an infrared imaging microbolometer comprising a membrane suspended above a substrate by means of support arms fixed to anchor pins. Said membrane comprises a support layer traversed by the anchor pins, an absorber deposited on the support layer and on the anchor pins. The absorber is patterned to form two electrodes. The membrane further comprises a dielectric layer deposited on said absorber and on the support layer, two conductive vias formed through the dielectric layer in contact with said two electrodes and a thermoresistive material disposed on a flat surface formed at the upper ends of said conductive vias.

### SUMMARY

The invention provides a sensing device device according to claim 1 and a method of manufacturing a sensing device according to claim 11.

A sensing device according to the invention includes a substrate, a circuit layer, and a plurality of sensing units. The circuit layer is disposed on the substrate and includes a plurality of driving circuits. The plurality of sensing units are disposed on the circuit layer, and each of the sensing units includes a supporting part and a sensing part. The supporting part is electrically connected to one of the plurality of driving circuits. The sensing part is electrically connected to the supporting part, and the sensing part is separated from the circuit layer by a first cavity through the supporting part. In a normal direction of the substrate, at least a portion of the supporting part is disposed between the circuit layer and the sensing part.

The sensing part comprises an absorbing layer and a sensing layer. The absorbing layer is disposed between the sensing layer and the supporting part, so that a second cavity separates the sensing layer and the supporting part.

A method of manufacturing a sensing device according to the invention includes the following. A substrate is provided. A circuit layer is formed on the substrate, and the circuit layer includes a plurality of driving circuits. A first sacrificial layer is formed on the circuit layer. A supporting part is formed on the first sacrificial layer, and the supporting part is electrically connected to one of the plurality of driving circuits. A second sacrificial layer is formed on the supporting part. A sensing part is formed on the second sacrificial layer, and the sensing part is electrically connected to the supporting part. The first sacrificial layer and the second sacrificial layer are removed.

In order to make the above-mentioned features and advantages of the disclosure more comprehensible, the following embodiments are described in detail with the accompanying drawings.

### BRIEF DESCRIPTION OF THE DRAWINGS

FIG. 1 to FIG. 10 are schematic flowcharts of a method of manufacturing a sensing device according to an embodiment of the disclosure.
FIG. 11 is a schematic circuit diagram of a sensing device according to an embodiment of the disclosure.

### DESCRIPTION OF THE EMBODIMENTS

Reference will now be made in detail to the exemplary embodiments of the disclosure, examples of which are illustrated in the accompanying drawings. Wherever possible, the same reference numerals are used in the drawings and descriptions to refer to the same or like parts.

The disclosure may be understood by referring to the following detailed description in conjunction with the accompanying drawings. It should be noted that, for the ease of understanding by readers and for the brevity of the accompanying drawings, multiple drawings in the disclosure only depict a portion of an electronic device, and certain elements in the drawings are not drawn according to the actual scale. In addition, the number and size of each of the elements in the drawings are for illustration purposes only and are not intended to limit the scope of the disclosure.

Certain terms are used throughout the description and the appended claims to refer to particular elements. Persons skilled in the art should understand that electronic device manufacturers may refer to the same element by different names. This disclosure does not intend to distinguish between elements that have the same function but have different names. In the following description and claims, words such as "comprising", "including", and "having" are openended words and should be interpreted as meaning "including but not limited to...". Accordingly, when the terms "comprising", "including", and/or "having" are used in the description of the disclosure, the presence of a corresponding feature, region, step, operation, and/or component are specified, but the presence of one or more of the corresponding feature, region, step, operation, and/or component are not excluded.

Directional wordings mentioned in the disclosure, such as "up," "down," "front," "back," "left," and "right," merely refer to directions in the accompanying drawings. Therefore, the directional wordings are used to illustrate rather than limit the disclosure. In the accompanying drawings, each of the drawings illustrates general features of methods, structures, and/or materials used in the particular embodiments. However, the drawings shall not be interpreted as defining or limiting the scope or nature covered by the embodiments. For example, the relative sizes, thicknesses, and positions of the layers, regions, and/or structures may be reduced or enlarged for clarity.

When a corresponding component (e.g., a film layer or region) is referred to as being "on" another component, it may be directly on the other component, or other components may be present therebetween. On the other hand, when a component is referred to as being "directly on" another component, there are no components in between, unless otherwise specified in the specification. Additionally, when a component is referred to as being "on" another component, the two are in a top-down relationship when viewed from above, and the component may be above or below the other component, depending on the orientation of the device.

The terms "equal to" or "the same", "substantially" or "approximately" are generally interpreted as being within 20% of a given value or range, or as being within 10%, 5%, 3%, 2%, 1%, or 0.5% of a given value or range.

The terms such as "first", "second", etc. used in the description and the appended claims are used to modify elements, which do not imply or represent that the (or these) elements have any previous ordinal numbers, and also does not represent the order of a certain element and another element, or the order of the manufacturing method. The use of these ordinal numbers is to merely clearly distinguish an element with a certain name from another element with the same name. The same terms may not be used in the appended claims and the description, and accordingly, the first component in the description may be the second component in the appended claims.

It should be noted that, in the following embodiments, features in several different embodiments may be replaced, reorganized, and mixed to complete other embodiments.

The electrical connection or coupling described in the disclosure may refer to direct connection or indirect connection. In the case of a direct connection, end points of two elements on a circuit directly connect to each other or connect to each other through a conductive wire. In the case of an indirect connection, a switch, a diode, a capacitor, an inductor, other suitable elements, or a combination thereof, but not limited thereto, is between the end points of the two elements on the circuit.

In the disclosure, the thickness, length, width, and area may be measured by using an optical microscope, and the thickness may be measured by a cross-sectional image in an electron microscope, but not limited thereto. In addition, any two values or directions used for comparison may have certain errors. If a first value is equal to a second value, it implies that there may be an error of about 10% between the first value and the second value; if a first direction is perpendicular to a second direction, an angle between the first direction and the second direction may be between 80 degrees and 100 degrees; if the first direction is parallel to the second direction, an angle between the first direction and the second direction may be between 0 degrees and 10 degrees.

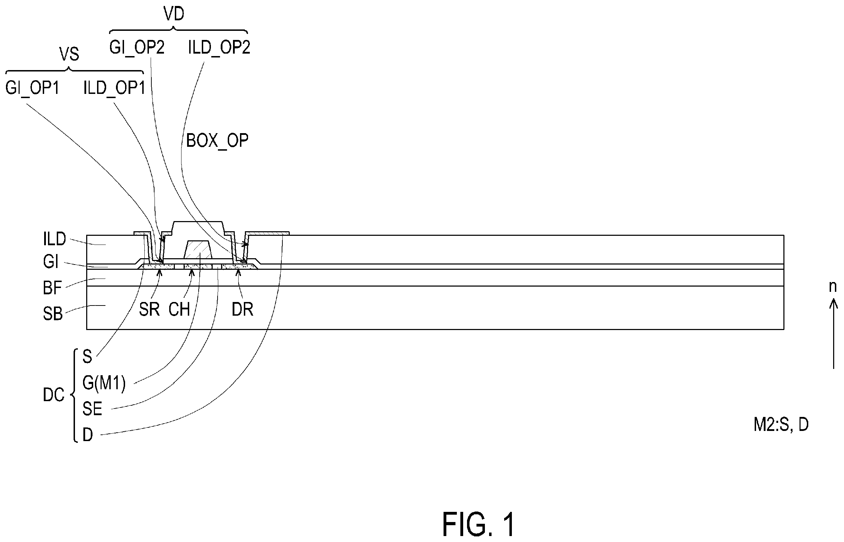

FIG. 1 to FIG. 10 are schematic flowcharts of a method of manufacturing a sensing device according to an embodiment of the invention.

Please refer to FIG. 1. First, a substrate SB is provided. The substrate SB may, for example, include a flexible substrate or an inflexible substrate, in which the material of the substrate SB may, for example, include glass, plastic, or a combination thereof. For example, the substrate SB may include quartz, sapphire, polymethyl methacrylate (PMMA), polycarbonate (PC), polyimide (PI), polyethylene terephthalate (PET), or other suitable materials or a combination of the above materials. In this embodiment, the material of the substrate SB is glass, but the disclosure is not limited thereto.

Please continue to refer to FIG. 1. Next, a circuit layer CIL is formed on the substrate SB. The circuit layer CIL includes, for example, a plurality of driving circuits DC, in which each of the plurality of driving circuits DC may include, for example, an active device, but the disclosure is not limited thereto.

In some embodiments, the circuit layer CIL may be formed on the substrate SB by performing the following operations, but the disclosure is not limited thereto.

In Step (1), a buffer layer BF is formed on the substrate SB, in which the buffer layer BF may, for example, have a good bonding property with subsequent film layers formed thereon, but the disclosure is not limited thereto. A method of forming the buffer layer BF may be, for example, forming on the substrate SB by using the chemical vapor deposition or other suitable processes, but the disclosure is not limited thereto. A material of the buffer layer BF may be, for example, an inorganic material (e.g., silicon oxide, silicon nitride, silicon oxynitride, or a stacked layer of at least two of the above materials). In some embodiments, the buffer layer BF may be a single-layer structure or a multi-layer structure, and the disclosure is not limited thereto.

In Step (2), a semiconductor layer SE is formed on the buffer layer BF. A method of forming the semiconductor layer SE may be, for example, first forming a semiconductor material layer (not shown) on the buffer layer BF by using the chemical vapor deposition or other suitable processes, and then performing a patterning process on the semiconductor material layer, but the disclosure is not limited thereto. In some embodiments, the semiconductor layer SE has a channel region CH and a source region SR and a drain region DR positioned on opposite sides of the channel region CH, in which the channel region CH and a gate G to be mentioned later overlap at least partially in a normal direction n of the substrate SB, and the source region SR and the drain region DR may be respectively electrically connected to a source S and a drain D to be mentioned later. In addition, in some embodiments, a light shielding layer (not shown) may be further formed between the buffer layer BF and the substrate SB, in which the light-shielding layer and the channel region CH of the semiconductor layer SE at least partially overlap in the normal direction n of the substrate SB, thereby reducing the deterioration of the channel region CH of the semiconductor layer SE due to light irradiation from external environment, but the disclosure is not limited thereto. A material of the semiconductor layer SE may include, for example, low temperature polysilicon (LTPS), metal oxide, amorphous silicon (a-Si), or a combination thereof, but the disclosure is not limited thereto. For example, the material of the semiconductor layer SE may include but is not limited to amorphous silicon, polysilicon, germanium, compound semiconductors (such as gallium nitride, silicon carbide, gallium arsenide, gallium phosphide, indium phosphide, indium arsenide, and/or or indium antimonide), alloy semiconductors (such as SiGe alloys, GaAsP alloys, AlInAs alloys, AlGaAs alloys, GaInAs alloys, GaInP alloys, GaInAsP alloys), or a combination of the above-mentioned. The material of the semiconductor layer SE may also include but is not limited to metal oxides, such as indium gallium zinc oxide (IGZO), indium zinc oxide (IZO), indium gallium zinc oxide (IGZTO), or organic semiconductors comprising polycyclic aromatic compounds, or a combination of the above-mentioned. In this embodiment, the material of the semiconductor layer SE is amorphous silicon, but the disclosure is not limited thereto.

In Step (3), a gate insulation layer GI, a first metal layer M1, and an insulation layer ILD are formed on the buffer layer BF, in which the gate insulation layer GI is, for example, disposed on the buffer layer BF, the first metal layer M1 includes, for example, the gate G and is disposed on the gate insulation layer GI, and the insulation layer ILD is, for example, disposed on the gate insulation layer GI and, for example, covers the gate G.

In some embodiments, the gate insulation layer GI has an opening GI_OP1 and an opening GI_OP2, and the insulation layer ILD has an opening ILD_OP1 and an opening ILD_OP2. The opening GI_OP1 and the opening ILD_OP1 may be connected as a via hole VS and together expose the source region SR of the semiconductor layer SE, and the opening GI_OP2 and the opening ILD_OP2 are connected as a via hole VD and together expose the drain region DR of the semiconductor layer SE.

A method of forming the gate insulation layer GI may be, for example, first forming a gate insulation material layer (not shown) on the buffer layer BF by using the chemical vapor deposition or other suitable processes, and then performing a patterning process on the gate insulation material layer to form the opening GI_OP1 and the opening GI_OP2, but the disclosure is not limited thereto. A material of the gate insulation layer GI may be, for example, an inorganic material (e.g., silicon oxide, silicon nitride, silicon oxynitride, or a stacked layer of at least two of the above materials). In some embodiments, the gate insulation layer GI may be a single-layer structure or a multi-layer structure, and the disclosure is not limited thereto.

A method of forming the first metal layer M1 may be, for example, first forming a first metal material layer (not shown) on the gate insulation layer GI by using the physical vapor deposition, metal chemical vapor deposition, or other suitable processes, and then performing a patterning process on the first metal material layer, but the disclosure is not limited thereto. A material of the first metal layer M1 may include, for example, a suitable conductive material, and the disclosure is not limited thereto.

A method of forming the insulation layer ILD may be, for example, first forming an insulation material layer (not shown) on the gate insulation layer GI by the chemical vapor deposition or other suitable processes, and then performing a patterning process on the insulation material layer to form the opening ILD_OP1 and the opening ILD_OP2, in which the opening ILD_OP1 and the opening ILD_OP2 may be formed in the same patterning process as the opening GI_OP1 and the opening GI_OP2 respectively, but the disclosure is not limited thereto. A material of the insulation layer ILD may be, for example, an inorganic material (e.g., silicon oxide, silicon nitride, silicon oxynitride, or a stacked layer of at least two of the above materials). In some embodiments, the insulation layer ILD may be a single-layer structure or a multi-layer structure, and the disclosure is not limited thereto.

In Step (4), a second metal layer M2 is formed on the insulation layer ILD, in which the second metal layer M2 includes the source S and the drain D separated from each other, the source S may be electrically connected to the source region SR of the semiconductor layer SE through the via hole VS, and the drain D may be electrically connected to the drain region DR of the semiconductor layer SE through the via hole VD. A method of forming the second metal layer M2 may be, for example, first forming a second metal material layer (not shown) on the insulation layer ILD by using the physical vapor deposition method, the metal chemical vapor deposition method, or other suitable processes, and then performing a patterning process on the second metal material layer, but the disclosure is not limited thereto. A material of the second metal layer M2 may include, for example, a suitable conductive material, and the disclosure is not limited thereto.

In some embodiments, the semiconductor layer SE, the gate G, the source S, and the drain D may form the driving circuit DC (an active device). It should be noted that, although the embodiment shows that the driving circuit DC is any top gate thin film transistor known to persons skilled in the art, the disclosure is not limited thereto.

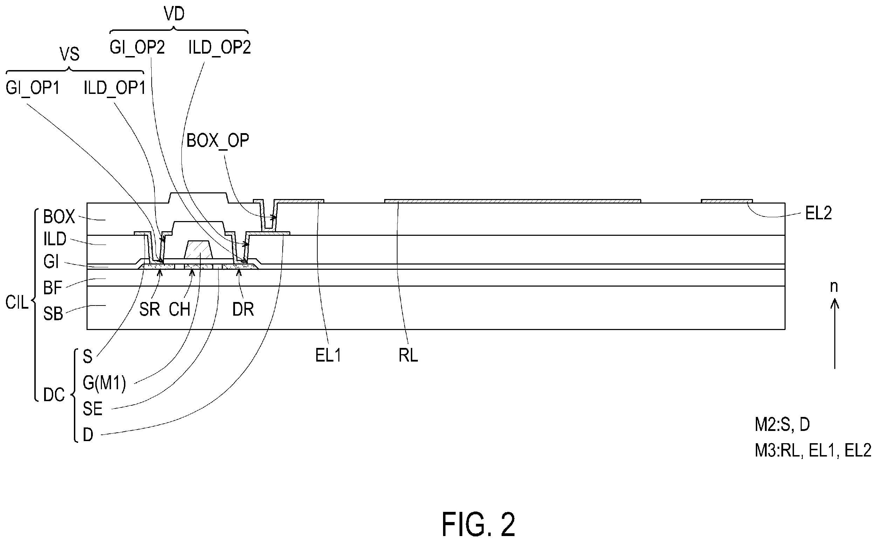

Please refer to FIG. 2. In Step (5): a buried oxide layer BOX is formed on the insulation layer ILD. In some embodiments, the buried oxide layer BOX has an opening BOX_OP, and a portion of the drain D is exposed through the opening BOX_OP.

A method of forming the buried oxide layer BOX may be, for example, first forming a buried oxide material layer (not shown) on the insulation layer ILD by using the chemical vapor deposition or other suitable processes, and then performing a patterning process on the buried oxide material layer to form the opening BOX_OP, but the disclosure is not limited thereto. A material of the buried oxide layer BOX may be, for example, silicon oxide, but the disclosure is not limited thereto.

So far, the manufacturing of the circuit layer CIL of this embodiment is completed, but the disclosure is not limited thereto.

Please continue to refer to FIG. 2. A third metal layer M3 is formed on the buried oxide layer BOX, in which the third metal layer M3 includes an electrical connection layer EL1, an electrical connection layer EL2, and a reflective layer RL that are separated from each other. The electrical connection layer EL1 may be electrically connected to the drain D through, for example, the opening BOX_OP of the buried oxide layer BOX, and the reflective layer RL may be electrically insulated from the driving circuit DC by, for example, the buried oxide layer BOX.

A method of forming the third metal layer M3 may be, for example, first forming a third metal material layer (not shown) on the buried oxide layer BOX by using the physical vapor deposition, the metal chemical vapor deposition, or other suitable processes, and then performing a patterning process on the third metal material layer, but the disclosure is not limited thereto. A material of the third metal layer M3 may, for example, include a conductive material having a high reflectivity for electromagnetic waves (e.g., electromagnetic waves with a wavelength of 8 µm to 14 µm and/or 3 µm to 5 µm). For example, a material of the third metal layer M3 may include aluminum, gold, chromium, nickel, alloys thereof, or other suitable materials, but the disclosure is not limited thereto.

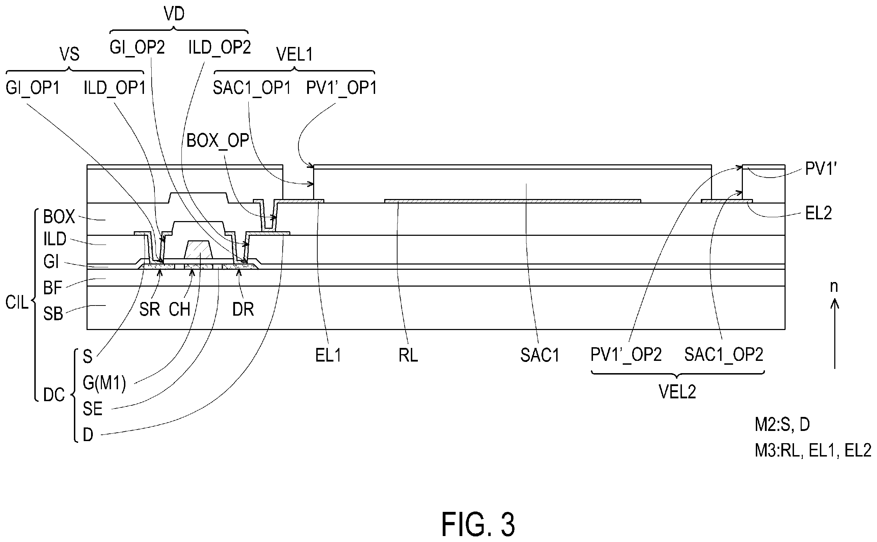

Referring to FIG. 3, a first sacrificial layer SAC1 is formed on the circuit layer CIL.

In some embodiments, the first sacrificial layer SAC1 may be formed on the circuit layer CIL by performing the following operations, but the disclosure is not limited thereto.

Firstly, first sacrificial material layers (not shown) are formed on the buried oxide layer BOX. Afterward, the above two first sacrificial material layers are patterned by using a mask to form the first sacrificial layers SAC1 having an opening SAC1_OP1 and an opening SAC1_OP2, in which the opening SAC1_OP1 exposes a portion of the electrical connection layer EL1, and the opening SAC1_OP2 exposes a portion of the electrical connection layer EL2. A material of the first sacrificial layer SAC1 may be, for example, an organic material (e.g., polyimide resin, epoxy resin, or acrylic resin). In this embodiment, the material of the first sacrificial layer SAC1 includes polyimide, acrylic resin, negative photoresist (SU-8), or parylene C, but the disclosure is not limited thereto.

Please continue to refer to FIG. 3, FIG. 4, and FIG. 5, a supporting part SUP' is formed on the first sacrificial layer SAC1, and the supporting part SUP' is electrically connected to one of the plurality of driving circuits DC.

In some embodiments, the supporting part SUP' may be formed on the first sacrificial layer SAC1 by performing the following operations, but the disclosure is not limited thereto.

Please continue to refer to FIG. 3. Firstly, an insulation layer PV1' is formed on the first sacrificial layer SAC1, in which the insulation layer PV1' has an opening PV1'_OP1 and an opening PV1'_OP2. It should be noted that the insulation layer PV1' may be used, for example, as a mask for forming the first sacrificial layer SAC1, but the disclosure is not limited thereto. In this embodiment, the opening PV1'_OP1 and the opening SAC1_OP1 are connected as a via hole VEL1 and together expose a portion of the electrical connection layer EL1, and the opening PV1'_OP2 and the opening SAC1_OP2 are connected as a via hole VEL2 and together expose a portion of the electrical connection layer EL2.

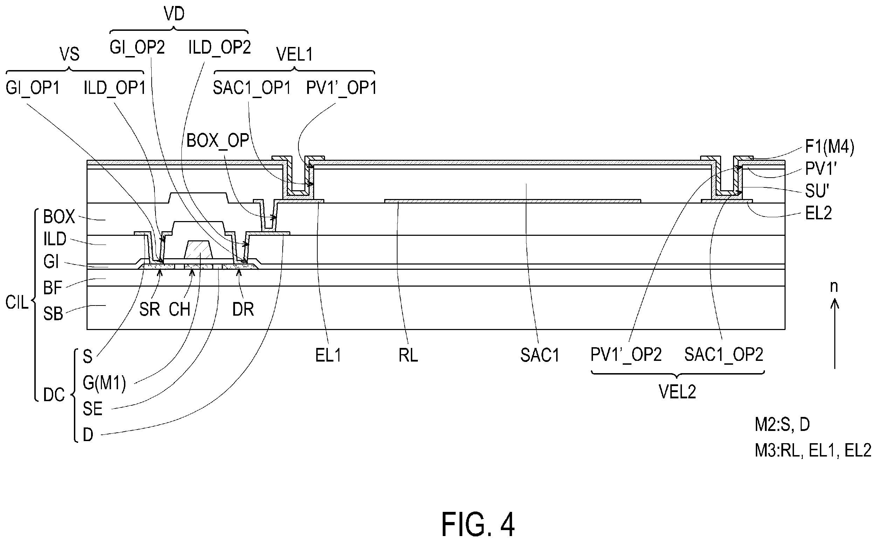

Please refer to FIG. 4. Next, a supporting layer SU' is formed on the first sacrificial layer SAC1, and the supporting layer SU' partially fills into the opening PV1'_OP1 and the opening PV1'_OP2 to be electrically connected to the electrical connection layer EL1 and the electrical connection layer EL2 respectively. A forming method of the supporting layer SU' may be, for example, by using the physical vapor deposition, the metal chemical vapor deposition, or other suitable processes, but the disclosure is not limited thereto. The supporting layer SU' may, for example, include suitable conductive materials to realize electrical connections with the electrical connection layer EL1 and the electrical connection layer EL2. In addition, the supporting layer SU' may also include materials having a high thermal resistance, so as to reduce the possibility of conducting thermal energy generated by an absorbing layer AB which will be described later absorbing electromagnetic waves to the supporting layer SU'. In this embodiment, the material of the supporting layer SU' includes titanium nitride (TiN), titanium aluminide (TiAl), titanium aluminum nitride (TiAlN), titanium aluminum oxide (TiAlO), titanium silicon aluminum (TiSiAl), tungsten Titanium nitride (TiW), titanium tungsten nitride (TiWN), or aluminum nitride (AlNx), but the disclosure is not limited thereto.

Please continue to refer to FIG. 4. Afterward, a fourth metal layer M4 is formed on the portion of the supporting layer SU' filling into the opening PV1'_OP1 and the opening PV1'_OP2. A method of forming the fourth metal layer M4 may be, for example, first forming a fourth metal material layer (not shown) on the supporting layer SU' by using the physical vapor deposition, the metal chemical vapor deposition, or other suitable processes, and then performing a patterning process on the fourth metal material layer, but the disclosure is not limited thereto. A material of the fourth metal layer M4 may, for example, include a suitable conductive material. In this embodiment, the material of the fourth metal layer M4 includes molybdenum (Mo), molybdenum nitride (MoN), tungsten-molybdenum alloy (MoW), or tungsten (W), but the disclosure is not limited thereto.

The fourth metal layer M4 may, for example, includes two fixing members F1 separated from each other, one of the fixing members F1 may be electrically connected to the electrical connection layer EL1 through the via hole VEL1 and the supporting layer SU', and the other fixing member F1 may be electrically connected to the electrical connection layer EL2 through the via hole VEL2 and the supporting layer SU'.

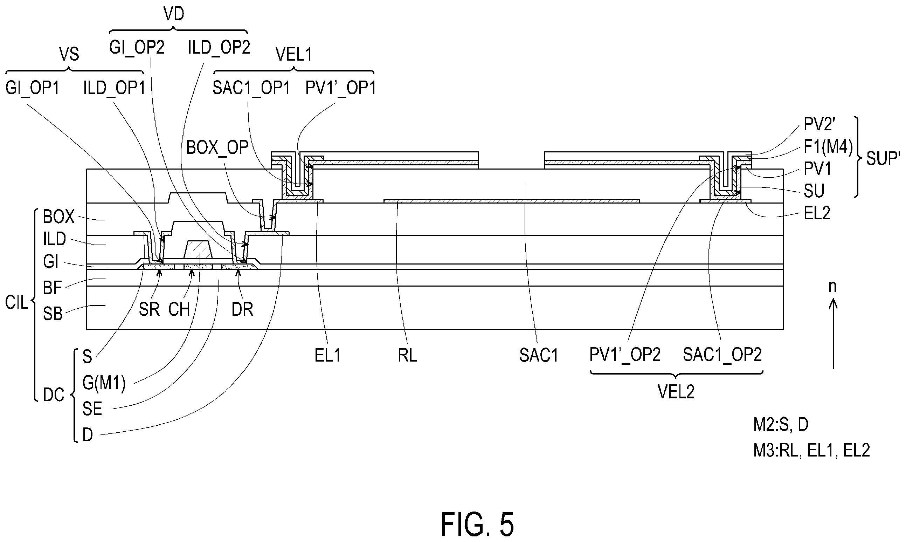

Please refer to FIG. 5. Further, an insulation layer PV1, a supporting layer SU, and an insulation layer PV2' are formed on the first sacrificial layer SAC1, which may be formed by performing the following operations, but the disclosure is not limited thereto.

First, an insulation material layer (not shown) is formed on the insulation layer PV1', in which the insulation material layer covers the supporting layer SU'. Next, the insulation material layer, the supporting layer SU', and the insulation layer PV1' are patterned by using a mask (not shown) to form the insulation layer PV2', the supporting layer SU, and the insulation layer PV1. It is worth noting that, the fourth metal layer M4 may be partially removed in the patterning process, but the disclosure is not limited thereto.

So far, the manufacturing of the supporting part SUP' of this embodiment is completed, but the disclosure is not limited thereto. In this embodiment, the supporting part SUP' includes the insulation layer PV1, the supporting layer SU, the fixing member F1, and the insulation layer PV2'.

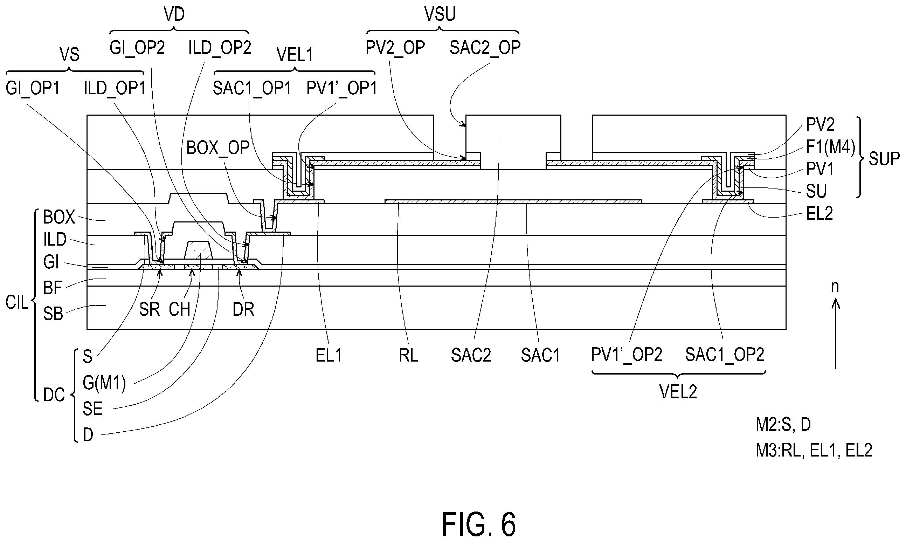

Referring to FIG. 6, a second sacrificial layer SAC2 is formed on the supporting part SUP'.

In some embodiments, the second sacrificial layer SAC2 may be formed on the supporting part SUP' by performing the following operations, but the disclosure is not limited thereto.

First, a second sacrificial material layer (not shown) is formed on the first sacrificial layer SAC1, in which the second sacrificial material layer covers the supporting part SUP'. Next, the second sacrificial material layer is patterned by using a mask (not shown) to form the second sacrificial layer SAC2 having an opening SAC2_OP. It is worth noting that, the patterning process also removes a portion of the insulation layer PV2' to form an insulation layer PV2 having an opening PV2_OP, in which the opening PV2_OP and the opening SAC2_OP are connected as a via hole VSU and together expose a portion of the supporting layer SU. A material of the second sacrificial layer SAC2 may be, for example, an organic material (e.g., polyimide resin, epoxy resin, or acrylic resin). In this embodiment, the material of the second sacrificial layer SAC2 includes polyimide, acrylic resin, negative photoresist (SU-8), or parylene C, but the disclosure is not limited thereto.

So far, the manufacturing of a supporting part SUP of this embodiment is completed, but the disclosure is not limited thereto. The supporting part SUP may, for example, be electrically connected to one of the plurality of driving circuits DC, in which the electrical connection between the supporting part SUP and the corresponding driving circuit DC may be realized, for example, through the electrical connection layer EL1.

In this embodiment, the supporting part SUP includes the insulation layer PV1, the supporting layer SU, the fixing member F1, and the insulation layer PV2. The supporting layer SU is, for example, disposed on the buried oxide layer BOX. The insulation layer PV1 is, for example, disposed between the supporting layer SU and the buried oxide layer BOX. The fixing member F1 is, for example, disposed on the supporting layer SU, and the fixing member F1 may fix the supporting layer SU on the buried oxide layer BOX by, for example, riveting, but the disclosure is not limited thereto. The insulation layer PV2 is, for example, disposed on the supporting layer SU and exposes a portion of the supporting layer SU.

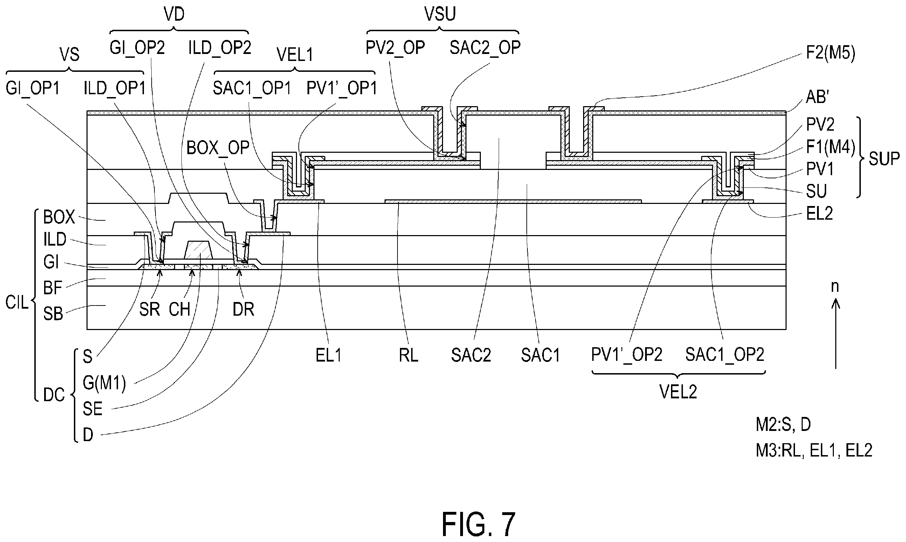

Referring to FIG. 7 to FIG. 9, a sensing part SEN is formed on the second sacrificial layer SAC2, and the sensing part SEN is electrically connected to the supporting part SUP.

In some embodiments, the sensing part SEN may be formed on the second sacrificial layer SAC2 by performing the following operations, but the disclosure is not limited thereto.

Referring to FIG. 7, an absorbing layer AB' is formed on the second sacrificial layer SAC2, and the absorbing layer AB' partially fills into the opening PV2_OP to be electrically connected to the supporting layer SU. A method of forming the absorbing layer AB' may be, for example, the physical vapor deposition, the metal chemical vapor deposition, or other suitable processes, but the disclosure is not limited thereto. The absorbing layer AB' may, for example, comprise a material having a high absorption rate for electromagnetic waves (e.g., electromagnetic waves with a wavelength of 8 µm to 14 µm and/or 3 µm to 5 µm). In this embodiment, the material of the absorbing layer AB' includes titanium (Ti), titanium nitride (TiN), platinum (Pt), gold (Au), nickel (Ni), niobium (Nb), or a combination thereof, but the disclosure is not limited thereto.

Please continue to refer to FIG. 7. Afterward, a fifth metal layer M5 is formed on the portion of the absorbing layer AB' filling into the opening PV2_OP, in which the fifth metal layer M5 includes two fixing members F2 separated from each other, each of which is electrically connected to the corresponding supporting layer SU through the via hole VSU. A forming method of the fifth metal layer M5 may be, for example, first forming a fifth metal material layer (not shown) on the absorbing layer AB' by using the physical vapor deposition, the metal chemical vapor deposition, or other suitable processes, and then performing a patterning process on the fifth metal material layer, but the disclosure is not limited thereto. A material of the fifth metal layer M5 may, for example, include a suitable conductive material. In this embodiment, the material of the fifth metal layer M5 includes molybdenum (Mo), molybdenum nitride (MoN), tungsten-molybdenum alloy (MoW), or tungsten (W), but the disclosure is not limited thereto.

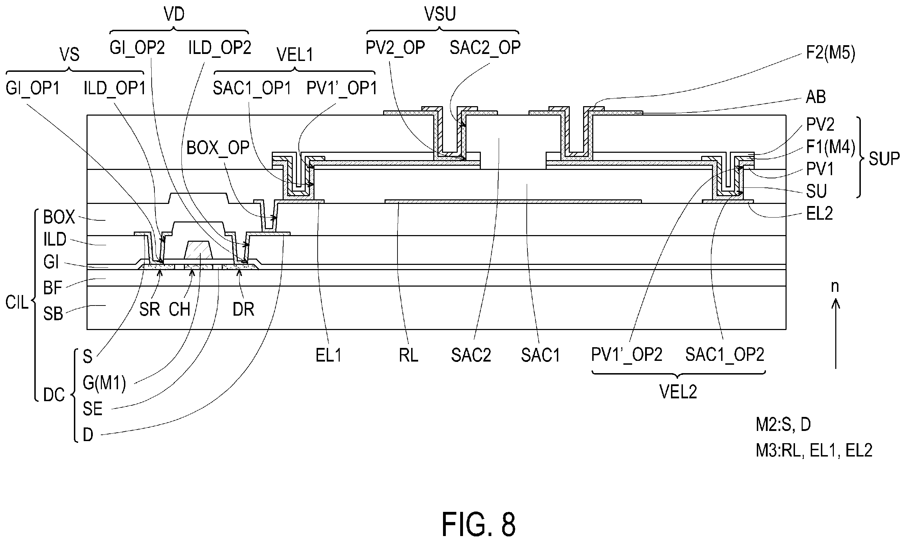

Referring to FIG. 8, the absorbing layer AB is formed, which may be formed, for example, by performing a patterning process on the absorbing layer AB' by using a mask (not shown).

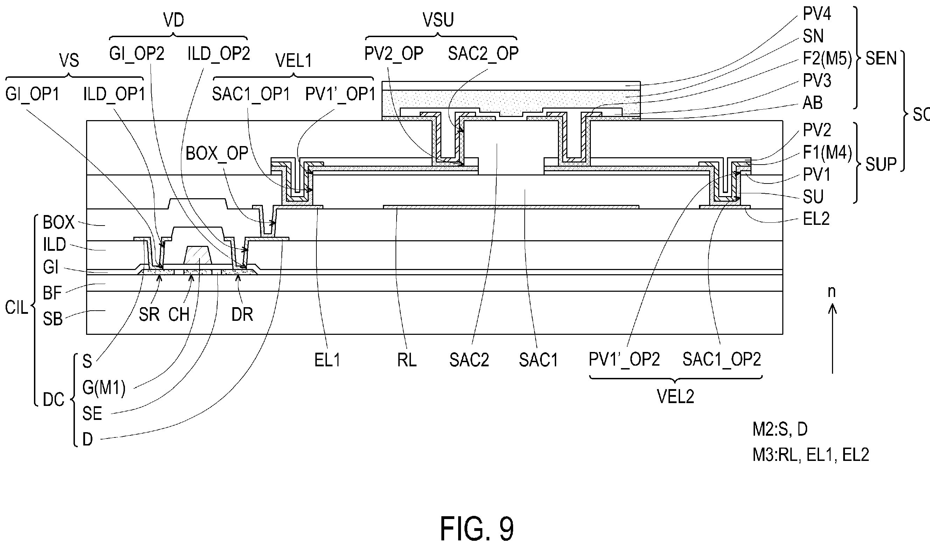

Referring to FIG. 9, an insulation layer PV3, a sensing layer SN, and an insulation layer PV4 are formed on the fifth metal layer M5, which may be formed by performing the following operations, but the disclosure is not limited thereto.

First, an insulation material layer (not shown) is formed on the fifth metal layer M5, in which the insulation material layer covers the fifth metal layer M5. Next, a patterning process is performed on the insulation material layer to form the insulation layer PV3, in which the insulation layer PV3 may expose a portion of the absorbing layer AB. A material of the insulation layer PV3 may, for example, include a material suitable for conducting thermal energy. In this embodiment, the material of the insulation layer PV3 includes silicon oxide, silicon nitride, or silicon oxynitride, but the disclosure is not limited thereto.

Afterward, a sensing material layer (not shown) and an insulation material layer (not shown) are sequentially formed on the fifth metal layer M5, in which the sensing material layer and the insulation material layer cover the fifth metal layer M5. Next, a patterning process is performed on the sensing material layer and the insulation material layer together to form the sensing layer SN and the insulation layer PV4 respectively, in which respective sides of the sensing layer SN, the insulation layer PV4, and the absorbing layer AB may be, for example, aligned in the normal direction n of the substrate SB. It is worth noting that, the absorbing layer AB may be partially removed in the patterning process, but the disclosure is not limited thereto.

The sensing layer SN may, for example, convert a received thermal signal into an electrical signal. In this embodiment, the sensing layer SN is a kind of thermistor, which has a characteristic of changing the resistance value as the temperature changes, but the disclosure is not limited thereto. A material of the sensing layer SN may include, for example, amorphous silicon (a-Si), vanadium oxide (VOx), yttrium barium copper oxide (YBaCuO), germanium silicon oxide (GeSiO), silicon germanium (SiGe), bismuth lanthanum strontium manganese oxides (BiLaSrMnO), or a combination thereof.

A material of the insulation layer PV4 may be, for example, an inorganic material (e.g., silicon oxide, silicon nitride, silicon oxynitride, or a stacked layer of at least two of the above materials), and the disclosure is not limited thereto.

So far, the manufacturing of the sensing part SEN of this embodiment is completed, but the disclosure is not limited thereto.

In this embodiment, the sensing part SEN includes the absorbing layer AB, the fixing member F2, the insulation layer PV3, the sensing layer SN, and the insulation layer PV4. The absorbing layer AB is, for example, disposed on the supporting part SUP, and disposed between the sensing layer SN and the supporting part SUP. The fixing member F2 is, for example, disposed on the absorbing layer AB, and the fixing member F2 may fix the absorbing layer AB on the supporting part SUP by, for example, riveting, but the disclosure is not limited thereto. The insulation layer PV3 is, for example, disposed between the absorbing layer AB and the sensing layer SN, in which the insulation layer PV3 may cover the fixing member F2, for example. The insulation layer PV4 is, for example, disposed on the sensing layer SN.

When electromagnetic waves irradiate the sensing part SEN, the absorbing layer AB in the sensing part SEN may absorb the electromagnetic waves and convert into thermal energy, and the heat may be conducted to the sensing layer SN through the insulation layer PV3 or be directly conducted to the sensing layer SN, so that the sensing layer SN changes the resistance value as the temperature rises after receiving the heat, and the change of the resistance value may be readout through a readout circuit RIC which will be introduced later to complete the sensing of the electromagnetic waves.

In this embodiment, in the normal direction n of the substrate SB, at least a portion of the supporting part SUP is disposed between the circuit layer CIL and the sensing part SEN. Through the above-mentioned configuration, the sensing part SEN may not have a limited sensing area due to being affected by a disposed position of the supporting part SUP, that is, the sensing part SEN can have a large sensing area, thereby increasing the range of the electromagnetic waves the sensing part SEN senses.

So far, the manufacturing of the sensing part SEN of this embodiment is completed, but the disclosure is not limited thereto.

It is worth noting that, the supporting part SUP and the sensing part SEN of this embodiment may be components of a sensing unit SC, but the disclosure is not limited thereto.

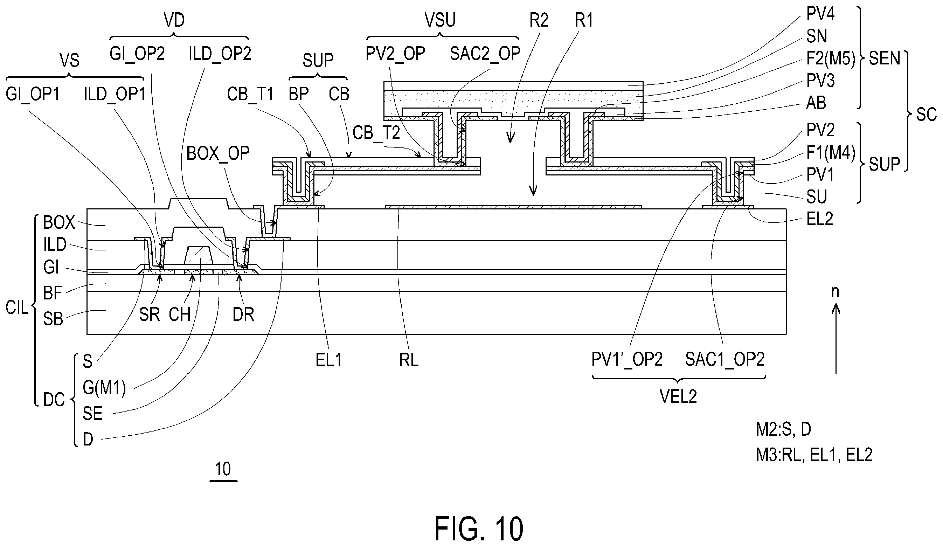

Referring to FIG. 10, the first sacrificial layer SAC1 and the second sacrificial layer SAC2 are removed. In this embodiment, a method of removing the first sacrificial layer SAC1 and the second sacrificial layer SAC2 includes injecting O2 plasma, but the disclosure is not limited thereto.

After removing the first sacrificial layer SAC1 and the second sacrificial layer SAC2, a first cavity R1 and a second cavity R2 are formed respectively, in which the sensing part SEN is separated from the first cavity R1 by, for example, the supporting part SUP and the circuit layer CIL, and the second cavity separates between the sensing layer SN of the sensing part SEN and, for example, the supporting part SUP. In some embodiments, the first cavity R1 may be connected to the second cavity R2 to form a resonant cavity for absorbing electromagnetic waves. In detail, a height of the first cavity R1 and/or a total height of the first cavity R1 and the second cavity R2 may be proportional to a quarter wavelength of the electromagnetic wave to be absorbed, so that the electromagnetic waves transmitted through the absorbing layer AB and incident to the cavity connected by the first cavity R1 and the second cavity R2 form resonance therein, thereby increasing the efficiency of a sensing device 10 in absorbing electromagnetic waves, and further improving the sensing sensitivity of the sensing device 10.

In this embodiment, at least a portion of the first cavity R1 is disposed between the reflective layer RL and the sensing part SEN. In detail, the reflective layer RL is at least separated from the absorbing layer AB of the sensing part SEN by the first cavity R1, for example, in the normal direction n of the substrate SB, and the reflective layer RL and the absorbing layer AB of the sensing part SEN overlap at least partially, for example, in the normal direction n of the substrate SB. Based on this, the electromagnetic waves transmitted through the absorbing layer AB may be reflected by the reflective layer RL back to the absorbing layer AB and be absorbed again, thereby increasing the efficiency of the sensing device 10 in absorbing the electromagnetic waves.

So far, the manufacturing of the sensing device 10 of this embodiment is completed, but the method of manufacturing the sensing device 10 in this disclosure is not limited thereto.

A structure of the sensing device 10 of the embodiment will be briefly introduced below with reference to FIG. 10, but the disclosure is not limited thereto.

In this embodiment, the sensing device 10 includes the substrate SB, the circuit layer CIL, and the plurality of sensing units SC. The circuit layer CIL is disposed on the substrate SB and includes the plurality of driving circuits DC. The plurality of sensing units SC are disposed on the circuit layer CIL, and each of the sensing units SC includes the supporting part SUP and the sensing part SEN. The supporting part SUP is electrically connected to one of the driving circuits DC. The sensing part SEN is electrically connected to the supporting part SUP, and the sensing part SEN is separated from the first cavity R1 by the supporting part SUP and the circuit layer CIL. In the normal direction n of the substrate SB, at least a portion of the supporting part SUP is disposed between the circuit layer CIL and the sensing part SEN. It is worth noting that, the detailed description regarding the substrate SB, the circuit layer CIL, and the plurality of sensing units SC may refer to the above-mentioned embodiments, and will not be repeated here.

In this embodiment, the circuit layer CIL of the sensing device 10 further includes the reflective layer RL. The reflective layer RL is, for example, electrically insulated from the driving circuit DC, and at least a portion of the first cavity R1 is disposed between the reflective layer RL and the sensing part SEN. It is worth noting that, the detailed description regarding the reflective layer RL may refer to the above-mentioned embodiments, and will not be repeated here.

In this embodiment, the supporting part SUP of the sensing device 10 includes a cantilever CB. In detail, the supporting part SUP of this embodiment may include the cantilever CB and a bridge pier BP connected to the cantilever CB. The cantilever CB has, for example, a first terminal part CB_T1 and a second terminal part CB_T2 opposite to each other, in which the first terminal part CB_T1 of the cantilever CB may be fixed to the circuit layer CIL by the bridge pier BP, and the second terminal part CB_T2 of the cantilever CB may, for example, support the sensing part SEN. In this embodiment, the supporting part SUP further includes the first fixing member F1, and the first fixing member F1 is disposed on the first terminal part CB_T1. It is worth noting that, the detailed description regarding the supporting part SUP may refer to the above-mentioned embodiments, and will not be repeated here.

In this embodiment, the sensing part SEN of the sensing device 10 includes the absorbing layer AB and the sensing layer SN, and the absorbing layer AB is disposed between the sensing layer SN and the supporting part SUP, so that the second cavity R2 separates between the sensing layer SN and the supporting part SUP. It is worth noting that, the detailed description regarding the sensing part SEN may refer to the above-mentioned embodiments, and will not be repeated here. In this embodiment, the sensing part SEN further includes the second fixing member F2, and the second fixing member F2 is disposed on the absorbing layer AB. It is worth noting that, the detailed description regarding the sensing part SEN may refer to the above-mentioned embodiments, and will not be repeated here.

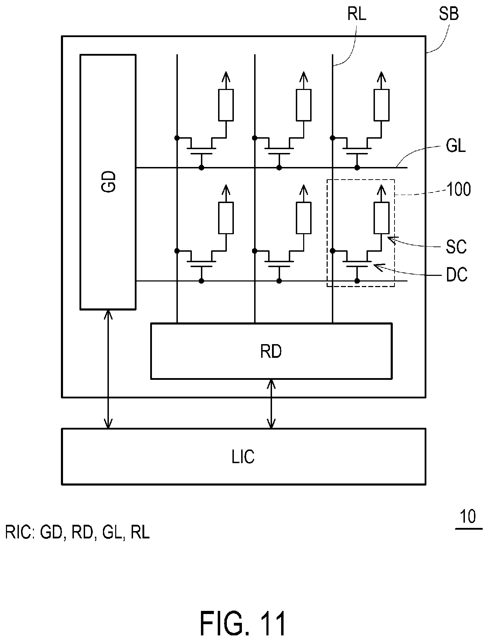

FIG. 11 is a schematic circuit diagram of a sensing device according to an embodiment of the disclosure.

Referring to FIG. 11, the sensing device 10 of the embodiment includes a plurality of sensing elements 100, the readout circuit RIC, and a logic circuit LIC.

The plurality of sensing elements 100 are, for example, disposed on the substrate SB in an array arrangement, in which each of the plurality of sensing elements 100 includes the driving circuit DC and the sensing unit SC. The driving circuit DC is coupled to the sensing unit SC to receive electrical signals from the sensing unit SC. The sensing unit SC includes, for example, the supporting part SUP and the sensing part SEN, which will not be repeated here.

The readout circuit RIC is, for example, coupled to the plurality of sensing elements 100 and includes a column driver GD, a readout driver RD, a gate line GL, and a readout line RL. The column driver GD is, for example, coupled to the gate G of the driving circuit DC through the gate line GL for providing a gate signal to the corresponding driving circuit DC to turn on. The readout driver RD is coupled to the source S of the driving circuit DC, for example, through the readout line RL to read the electrical signals from the sensing unit SC.

The logic circuit LIC is, for example, coupled to the column driver GD and the readout driver RD, for controlling the column driver GD and the readout driver RD. In some embodiments, the logic circuit LIC may include an application specific integrated circuit (ASIC), but the disclosure is not limited thereto.

In summary, in the sensing device provided by some embodiments of the disclosure, at least a portion of the supporting part is disposed between the circuit layer and the sensing part in the normal direction of the substrate. Through the above-mentioned configuration, the sensing part in the sensing device of some embodiments of the disclosure may not have a limited sensing area due to being affected by the disposed position of the supporting part, that is, the sensing part can have a large sensing area, thereby increasing the range of the electromagnetic waves the sensing part senses, so as to improve the efficiency of sensing electromagnetic waves of the sensing device according to some embodiments of the disclosure.

## Claims

1. A sensing device (10), comprising:
a substrate (SB);
a circuit layer (CIL) disposed on the substrate (SB), and the circuit layer (CIL) comprising a plurality of driving circuits (DC); and
a plurality of sensing units (SC) disposed on the circuit layer (CIL), and each of the sensing units (SC) comprising:
a supporting part (SUP) electrically connected to one of the plurality of driving circuits (DC); and
a sensing part (SEN) electrically connected to the supporting part (SUP), wherein the sensing part (SEN) is separated from the circuit layer (CIL) by a first cavity (R1) through the supporting part (SUP),
wherein in a normal direction (n) of the substrate (SB), at least a portion of the supporting part (SUP) is disposed between the circuit layer (CIL) and the sensing part (SEN),
wherein
the sensing part (SEN) comprises an absorbing layer (AB) and a sensing layer (SN), and the absorbing layer (AB) is disposed between the sensing layer (SN) and the supporting part (SUP),
**characterized in that** a second cavity (R2) separates the sensing layer (SN) and the supporting part (SUP).

2. The sensing device (10) according to claim 1, wherein the circuit layer (CIL) further comprises a reflective layer (RL), the reflective layer (RL) is electrically insulated from the driving circuit (DC), and at least a portion of the first cavity (R1) is disposed between the reflective layer (RL) and the sensing part (SEN).

3. The sensing device (10) according to claim 1, wherein the supporting part (SUP) comprises a cantilever (CB), a first terminal part (CB_T1) of the cantilever (CB) is fixed to the circuit layer (CIL), and a second terminal part (CB_T2) of the cantilever (CB) supports the sensing part (SEN).

4. The sensing device (10) according to claim 3, wherein the supporting part (SUP) further comprises a first fixing member (F1), and the first fixing member (F1) is disposed on the first terminal part (CB_T1).

5. The sensing device (10) according to claim 4, wherein the supporting part (SUP) further comprises a supporting layer (SU), and the first fixing member (F1) is disposed on the supporting layer (SU).

6. The sensing device (10) according to claim 1, wherein the sensing part (SEN) further comprises a second fixing member (F2), and the second fixing member (F2) is disposed on the absorbing layer (AB).

7. The sensing device (10) according to claim 1, wherein respective sides of the sensing layer (SN) and the absorbing layer (AB) are aligned in the normal direction (n) of the substrate (SB).

8. The sensing device (10) according to claim 1, wherein a material of the absorbing layer (AB) comprises Ti, TiN, Pt, Au, Ni, Nb, or a combination thereof.

9. The sensing device (10) according to claim 1, wherein a material of the sensing layer (SN) comprises a-Si, VOx, YBaCuO, GeSiO, SiGe, BiLaSrMnO, or a combination thereof.

10. The sensing device (10) according to claim 1, further comprising a readout circuit (RIC) and a logic circuit (LIC), the readout circuit (RIC) is coupled to the plurality of driving circuits (DC), and the logic circuit (LIC) is coupled to the readout circuit (RIC).

11. A method of manufacturing a sensing device (10), comprising:
providing a substrate (SB);
forming a circuit layer (CIL) on the substrate (SB), and the circuit layer (CIL) comprises a plurality of driving circuits (DC);
forming a first sacrificial layer (SAC1) on the circuit layer (CIL);
forming a supporting part (SUP) on the first sacrificial layer (SAC1), and the supporting part (SUP) being electrically connected to one of the plurality of driving circuits (DC);
forming a second sacrificial layer (SAC2) on the supporting part (SUP);
forming a sensing part (SEN) on the second sacrificial layer (SAC2), and the sensing part (SEN) being electrically connected to the supporting part (SUP); and
removing the first sacrificial layer (SAC1) and the second sacrificial layer (SAC2).

12. The method of manufacturing the sensing device (10) according to claim 11, wherein a method of forming the supporting part (SUP) comprises:
patterning the first sacrificial layer (SAC1) to form a first opening (SAC1_OP1, SAC1_OP2);
forming a supporting layer (SU) on the first sacrificial layer (SAC1), and the supporting layer (SU) partially filling into the first opening (SAC1_OP1, SAC1_OP2); and
forming a first metal layer (M4) on the portion of the supporting layer (SU) filling into the first opening (SAC1_OP1, SAC1_OP2).

13. The method of manufacturing the sensing device (10) according to claim 11, wherein a method of forming the sensing part (SEN) comprises:
patterning the second sacrificial layer (SAC2) to form a second opening (SAC2_OP);
forming an absorbing layer (AB) on the second sacrificial layer (SAC2), and the absorbing layer (AB) partially filling into the second opening (SAC2_OP);
forming a second metal layer (M5) on the portion of the absorbing layer (AB) filling into the second opening (SAC2_OP); and
forming a sensing layer (SN) on the second metal layer (M5).

14. The method of manufacturing a sensing device (10) according to claim 11, wherein a method of removing the first sacrificial layer (SAC1) and the second sacrificial layer (SAC2) comprises injecting O2 plasma.

## Patentansprüche

1. Sensorvorrichtung (10), umfassend:
ein Substrat (SB);
eine auf dem Substrat (SB) angeordnete Schaltungsschicht (CIL), wobei die Schaltungsschicht (CIL) eine Vielzahl von Ansteuerschaltungen (DC) umfasst; und
eine Vielzahl von Sensoreinheiten (SC), die auf der Schaltungsschicht (CIL) angeordnet sind, wobei jede der Sensoreinheiten (SC) umfasst:
ein Tragelement (SUP), das elektrisch mit einer der Vielzahl von Ansteuerschaltungen (DC) verbunden ist; und
ein Sensorelement (SEN), das elektrisch mit dem Tragelement (SUP) verbunden ist, wobei das Sensorelement (SEN) durch einen ersten Hohlraum (R1) durch das Tragelement (SUP) von der Schaltungsschicht (CIL) getrennt ist,
wobei in einer Normalenrichtung (n) des Substrats (SB) zumindest ein Abschnitt des Tragelements (SUP) zwischen der Schaltungsschicht (CIL) und dem Sensorelement (SEN) angeordnet ist,
wobei das Sensorelement (SEN) eine Absorptionsschicht (AB) und eine Sensorschicht (SN) umfasst, wobei die Absorptionsschicht (AB) zwischen der Sensorschicht (SN) und dem Tragelement (SUP) angeordnet ist,
**dadurch gekennzeichnet, dass**
ein zweiter Hohlraum (R2) die Sensorschicht (SN) und das Tragelement (SUP) trennt.

2. Sensorvorrichtung (10) nach Anspruch 1, wobei die Schaltungsschicht (CIL) ferner eine reflektierende Schicht (RL) umfasst, wobei die reflektierende Schicht (RL) elektrisch von der Ansteuerschaltung (DC) isoliert ist und mindestens ein Abschnitt des ersten Hohlraums (R1) zwischen der reflektierenden Schicht (RL) und dem Sensorelement (SEN) angeordnet ist.

3. Sensorvorrichtung (10) nach Anspruch 1, wobei das Tragelement (SUP) einen Ausleger (CB) umfasst, wobei ein erstes Anschlusselement (CB_T1) des Auslegers (CB) an der Schaltungsschicht (CIL) befestigt ist und ein zweites Anschlusselement (CB_T2) des Auslegers (CB) das Sensorelement (SEN) trägt.

4. Sensorvorrichtung (10) nach Anspruch 3, wobei das Tragelement (SUP) ferner ein erstes Befestigungselement (F1) umfasst und das erste Befestigungselement (F1) an dem ersten Anschlusselement (CB_T1) angeordnet ist.

5. Sensorvorrichtung (10) nach Anspruch 4, wobei das Tragelement (SUP) ferner eine Tragschicht (SU) umfasst und das erste Befestigungselement (F1) auf der Tragschicht (SU) angeordnet ist.

6. Sensorvorrichtung (10) nach Anspruch 1, wobei das Sensorelement (SEN) ferner ein zweites Befestigungselement (F2) umfasst und das zweite Befestigungselement (F2) auf der Absorptionsschicht (AB) angeordnet ist.

7. Sensorvorrichtung (10) nach Anspruch 1, wobei die jeweiligen Seiten der Sensorschicht (SN) und der Absorptionsschicht (AB) in der Normalenrichtung (n) des Substrats (SB) zueinander ausgerichtet sind.

8. Sensorvorrichtung (10) nach Anspruch 1, wobei ein Material der Absorptionsschicht (AB) Ti, TiN, Pt, Au, Ni, Nb oder eine Kombination davon umfasst.

9. Sensorvorrichtung (10) nach Anspruch 1, wobei ein Material der Sensorschicht (SN) a-Si, VOx, YBaCuO, GeSiO, SiGe, BiLaSrMnO oder eine Kombination davon umfasst.

10. Sensorvorrichtung (10) nach Anspruch 1, ferner umfassend eine Ausleseschaltung (RIC) und eine Logikschaltung (LIC), wobei die Ausleseschaltung (RIC) mit der Vielzahl von Ansteuerschaltungen (DC) gekoppelt ist und die Logikschaltung (LIC) mit der Ausleseschaltung (RIC) gekoppelt ist.

11. Verfahren zur Herstellung einer Sensorvorrichtung (10), umfassend:
Bereitstellen eines Substrats (SB);
Bilden einer Schaltungsschicht (CIL) auf dem Substrat (SB), wobei die Schaltungsschicht (CIL) eine Vielzahl von Ansteuerschaltungen (DC) umfasst;
Bilden einer ersten Opferschicht (SAC1) auf der Schaltungsschicht (CIL);
Bilden eines Tragelements (SUP) auf der ersten Opferschicht (SAC1), wobei das Tragelement (SUP) elektrisch mit einer der Vielzahl von Ansteuerschaltungen (DC) verbunden ist;
Bilden einer zweiten Opferschicht (SAC2) auf dem Tragelement (SUP);
Bilden eines Sensorelements (SEN) auf der zweiten Opferschicht (SAC2), wobei das Sensorelement (SEN) elektrisch mit dem Tragelement (SUP) verbunden ist; und
Entfernen der ersten Opferschicht (SAC1) und der zweiten Opferschicht (SAC2).

12. Verfahren zur Herstellung der Sensorvorrichtung (10) nach Anspruch 11, wobei ein Verfahren zum Bilden des Tragelements (SUP) umfasst:
Strukturieren der ersten Opferschicht (SAC1), um eine erste Öffnung (SAC1_OP1, SAC1_OP2) zu bilden;
Bilden einer Trägerschicht (SU) auf der ersten Opferschicht (SAC1), wobei die Trägerschicht (SU) die erste Öffnung (SAC1_OP1, SAC1_OP2) teilweise ausfüllt; und
Bilden einer ersten Metallschicht (M4) auf dem Abschnitt der Trägerschicht (SU), die die erste Öffnung (SAC1_OP1, SAC1_OP2) teilweise ausfüllt.

13. Verfahren zur Herstellung der Sensorvorrichtung (10) nach Anspruch 11, wobei ein Verfahren zum Bilden des Sensorelements (SEN) umfasst:
Strukturieren der zweiten Opferschicht (SAC2), um eine zweite Öffnung (SAC2_OP) zu bilden;
Bilden einer Absorptionsschicht (AB) auf der zweiten Opferschicht (SAC2), wobei die Absorptionsschicht (AB) die zweite Öffnung (SAC2_OP) teilweise ausfüllt;
Bilden einer zweiten Metallschicht (M5) auf dem Abschnitt der Absorptionsschicht (AB), die die zweite Öffnung (SAC2_OP) teilweise ausfüllt; und
Bilden einer Sensorschicht (SN) auf der zweiten Metallschicht (M5).

14. Verfahren zur Herstellung einer Sensorvorrichtung (10) nach Anspruch 11, wobei ein Verfahren zum Entfernen der ersten Opferschicht (SAC1) und der zweiten Opferschicht (SAC2) das Einleiten von O2-Plasma umfasst.

## Revendications

1. Dispositif de détection (10), comprenant :un substrat (SB) ;une couche de circuit (CIL) disposée sur le substrat (SB), ladite couche de circuit (CIL) comprenant une pluralité de circuits d'attaque (DC) ; et
une pluralité d'unités de détection (SC) disposées sur la couche de circuit (CIL), chacune desdites unités de détection (SC) comprenant :
une partie de support (SUP) connectée électriquement à l'un des circuits d'attaque (DC) ; et
une partie de détection (SEN) connectée électriquement à la partie de support (SUP), dans lequel la partie de détection (SEN) est séparée de la couche de circuit (CIL) par une première cavité (R1) traversant la partie de support (SUP),dans lequel, dans une direction normale (n) du substrat (SB), au moins une partie de la partie de support (SUP) est disposée entre la couche de circuit (CIL) et la partie de détection (SEN), dans lequel la partie de détection (SEN) comprend une couche absorbante (AB) et une couche de détection (SN), et la couche absorbante (AB) est disposée entre la couche de détection (SN) et la partie de support (SUP), **caractérisé en ce qu'**une deuxième cavité (R2) sépare la couche de détection (SN) de la partie de support (SUP).

2. Dispositif de détection (10) selon la revendication 1, dans lequel la couche de circuit (CIL) comprend en outre une couche réfléchissante (RL), la couche réfléchissante (RL) est isolée électriquement du circuit d'attaque (DC), et au moins une partie de la première cavité (R1) est disposée entre la couche réfléchissante (RL) et la partie de détection (SEN).

3. Dispositif de détection (10) selon la revendication 1, dans lequel la partie de support (SUP) comprend un cantilever (CB), une première partie d'extrémité (CB_T1) du cantilever (CB) est fixée à la couche de circuit (CIL), et une deuxième partie d'extrémité (CB_T2) du cantilever (CB) supporte la partie de détection (SEN).

4. Dispositif de détection (10) selon la revendication 3, dans lequel la partie de support (SUP) comprend en outre un premier élément de fixation (F1), et le premier élément de fixation (F1) est disposé sur la première partie d'extrémité (CB_T1).

5. Dispositif de détection (10) selon la revendication 4, dans lequel la partie de support (SUP) comprend en outre une couche de support (SU), et le premier élément de fixation (F1) est disposé sur la couche de support (SU).

6. Dispositif de détection (10) selon la revendication 1, dans lequel la partie de détection (SEN) comprend en outre un deuxième élément de fixation (F2), et le deuxième élément de fixation (F2) est disposé sur la couche absorbante (AB).

7. Dispositif de détection (10) selon la revendication 1, dans lequel les faces respectives de la couche de détection (SN) et de la couche absorbante (AB) sont alignées dans la direction normale (n) du substrat (SB).

8. Dispositif de détection (10) selon la revendication 1, dans lequel un matériau de la couche absorbante (AB) comprend Ti, TiN, Pt, Au, Ni, Nb, ou une combinaison de ceux-ci.

9. Dispositif de détection (10) selon la revendication 1, dans lequel un matériau de la couche de détection (SN) comprend a-Si, VOx, YBaCuO, GeSiO, SiGe, BiLaSrMnO, ou une combinaison de ceux-ci.

10. Dispositif de détection (10) selon la revendication 1, comprenant en outre un circuit de lecture (RIC) et un circuit logique (LIC), le circuit de lecture (RIC) étant couplé à la pluralité de circuits d'attaque (DC), et le circuit logique (LIC) étant couplé au circuit de lecture (RIC).

11. Procédé de fabrication d'un dispositif de détection (10), comprenant :la fourniture d'un substrat (SB) ;la formation d'une couche de circuit (CIL) sur le substrat (SB), la couche de circuit (CIL) comprenant une pluralité de circuits d'attaque (DC) ;la formation d'une première couche sacrificielle (SAC1) sur la couche de circuit (CIL) ;la formation d'une partie de support (SUP) sur la première couche sacrificielle (SAC1), la partie de support (SUP) étant connectée électriquement à l'un des circuits d'attaque (DC) ;la formation d'une deuxième couche sacrificielle (SAC2) sur la partie de support (SUP) ;la formation d'une partie de détection (SEN) sur la deuxième couche sacrificielle (SAC2), la partie de détection (SEN) étant connectée électriquement à la partie de support (SUP) ; et
l'élimination de la première couche sacrificielle (SAC1) et de la deuxième couche sacrificielle (SAC2).

12. Procédé de fabrication d'un dispositif de détection (10) selon la revendication 11, dans lequel un procédé de formation de la partie de support (SUP) comprend :la structuration de la première couche sacrificielle (SAC1) pour former une première ouverture (SAC1_OP1, SAC1_OP2) ;la formation d'une couche de support (SU) sur la première couche sacrificielle (SAC1), la couche de support (SU) remplissant partiellement les premières ouvertures (SAC1_OP1, SAC1_OP2) ; et
la formation d'une première couche métallique (M4) sur la partie de la couche de support (SU) remplissant les premières ouvertures (SAC1_OP1, SAC1_OP2).

13. Procédé de fabrication d'un dispositif de détection (10) selon la revendication 11, dans lequel un procédé de formation de la partie de détection (SEN) comprend :la structuration de la deuxième couche sacrificielle (SAC2) pour former une deuxième ouverture (SAC2_OP) ;la formation d'une couche absorbante (AB) sur la deuxième couche sacrificielle (SAC2), la couche absorbante (AB) remplissant partiellement la deuxième ouverture (SAC2_OP) ;la formation d'une deuxième couche métallique (M5) sur la partie de la couche absorbante (AB) qui remplit la deuxième ouverture (SAC2_OP) ; et
la formation d'une couche de détection (SN) sur la deuxième couche métallique (M5).

14. Procédé de fabrication d'un dispositif de détection (10) selon la revendication 11, dans lequel un procédé d'élimination de la première couche sacrificielle (SAC1) et de la deuxième couche sacrificielle (SAC2) comprend l'injection d'un plasma d'O2.
